Europäisches Patentamt

(19) European Patent Office

Office européen des brevets

(11) Veröffentlichungsnummer: **0 061 101**
**B1**

# (12) EUROPÄISCHE PATENTSCHRIFT

(45) Veröffentlichungstag der Patentschrift:
06.03.85

(21) Anmeldenummer: 82102024.5

(22) Anmeldetag: 12.03.82

(51) Int. Cl.⁴: **H 03 K 17/78**, H 03 K 17/94,
G 06 F 3/02

(54) **Tastenfeld.**

(30) Priorität: 23.03.81 DE 3111371

(43) Veröffentlichungstag der Anmeldung:
29.09.82 Patentblatt 82/39

(45) Bekanntmachung des Hinweises auf die Patenterteilung:
06.03.85 Patentblatt 85/10

(84) Benannte Vertragsstaaten:
**BE NL**

(56) Entgegenhaltungen:
**DE - A - 2 517 030**
**DE - A - 2 824 399**
**DE - B - 1 231 757**
**DE - B - 1 299 706**
**US - A - 4 092 640**

**IBM TECHNICAL DISCLOSURE BULLETIN, Band 20, Nr.
9, Februar 1978, J.E. FOX "Scanned optical keyboard",
Seiten 3615, 3616**

(73) Patentinhaber: **Siemens Aktiengesellschaft, Berlin und
München Wittelsbacherplatz 2, D-8000 München 2 (DE)**

(72) Erfinder: **Rekow, Heinz-Peter, St. Johann 6,
D-8520 Erlangen (DE)**

## Beschreibung

Die Erfindung betrifft ein Tastenfeld mit einer Vielzahl eng benachbarter geordneter Einzeltaster zur Betätigung elektrischer Schaltkreise nach dem Oberbegriff des Patentanspruchs.

Ein Tastenfeld der eingangs genannten Art ist aus IBM Technical Disclosure Bulletin, Vol. 20, Nr. 9, Febr. 1978, Seiten 3615 und 3616, bekannt. Hierbei ist jedem Einzeltaster eine Leuchtdiode zugeordnet. Die von einer Steuervorrichtung mit Zähleinrichtungen und Dekodern fortlaufend mit einer im Vergleich zur Betätigungsdauer der Einzeltaster hohen Frequenz angesteuerten Leuchtdioden — wobei sämtliche Leuchtdioden innerhalb einer Millisekunde durchlaufend angesteuert werden — beleuchten die jeweils zugeordneten unbetätigten Einzeltaster. Jeder mechanisch verstellbare Einzeltaster ist mit einer flexiblen Lichtleitfaser gekuppelt, die bei unbetätigtem Einzeltaster vor der Leuchtdiode liegt und bis zu einer allen Lichtleitfasern gemeinsamen lichtfokussierenden Optik reicht, die einem gemeinsamen Lichtsensor als Detektor vorgeordnet ist, der den angesteuerten betätigten Einzeltaster feststellt, wobei dessen durch verminderten Stromfluß nichtleuchtende Leuchtdiode als Signalquelle wirkt. Der Aufwand für ein solches Tastenfeld ist wegen der Notwendigkeit gesonderter mechanisch betätigbarer Einzeltaster für jede Leuchtdiode und die Kupplung jedes Einzeltasters mit einer Lichtleitfaser sowie deren Verlegung zu einer gemeinsamen Optik aufwendig und platzfordernd. Außerdem ist nach Wegfall der Betätigung eines Einzeltasters keine optische Erkennbarkeit mehr gegeben, da alle nichtbetätigten Einzeltaster in gleicher Weise beim Ansteuern beleuchtet erscheinen. Außerdem verbietet eine solche Ausführung die Unterbringung vieler Einzeltaster auf kleinstmöglicher Fläche.

Aus der US-A-4 092 640 ist ein ähnliches Tastenfeld mit geordneten Einzeltastern aus kapazitätsabhängig betätigbaren Leuchtdioden bekannt, das eine aufwendige Beschaltung und Ausführung der einzelnen Leuchtdioden erfordert. Hier ist keine fortlaufende Ansteuerung der einzelnen Leuchtdioden vorgesehen, sondern alle Leuchtdioden sind im unbetätigten Zustand unbeleuchtet. Bei Berühren einer Leuchtdiode wird diese aufgrund des kapazitiven Einflusses des Betätigenden stromführend und leuchtet auf, solange bis sie durch erneutes Berühren wieder aufgrund der kapazitiven Beeinflussung durch ihre Beschaltung stromsperrend gesteuert wird. Die Lichtemission der beleuchteten Leuchtdioden dient dabei aber nur zur Anzeige des Schaltzustandes, nicht aber zur Steuerung von abhängigen Stromkreisen.

Tastenfelder mit einer Vielzahl von Tastmulden in einer lichtleitenden Trägerfläche mit jeder Tastmulde zugeordnetem Lichtsensor und einer oder mehreren Lichtquellen zur inneren Ausleuchtung der Trägerfläche sind aus Fig. 1 der DE-B-1 231 757 und der Fig. 5 der DE-B-1 299 706 bekannt. In die Tastmulden können z. B. Fingerspitzen oder von diesen betätigbare lichtabschirmende Körper eingebracht werden, die die von der lichtleitenden beleuchteten Trägerfläche ausgehenden Lichtstrahlen gegen den der Tastmulde vorgeordneten Lichtsensor abschirmen.

Die Ausbildung der Tastmulde nach Form und Größe und die eventuelle Anbringung gesonderter lichtabschirmender Körper bedeutet außer dem erheblichen Aufwand auch noch einen entsprechenden Platzbedarf für die Unterbringung der Lichtsensoren in der Trägerfläche selbst, da entweder eine Bündelung der den Lichtsensoren zugeordneten Lichtstrahlanteile oder eine Lichtabschirmung der lichtleitenden Trägerfläche nach außen außerhalb der Tastmulden notwendig ist.

Aus der Fig. 7 der DE-A1-2 517 030 ist ein Tastenfeld mit verteilten Lichtquellen und verteilten Lichtsensoren bekannt, bei der jeder Lichtquelle mindestens ein Lichtsensor so zugeordnet ist, daß das emittierte Licht nur im abgelenkten Zustand, z. B. durch einen Finger abgelenkt auf den oder die zugeordneten Lichtsensoren gelangen kann.

Aus der DE-A1-2 824 399, insbesondere Fig. 3, ist ein Tastenfeld mit mehreren optoelektronischen Schaltkreiselementen bekannt, von denen jedes dieser Schaltkreiselemente aus einer Leuchtdiode, einer Strahlungsausbreitungseinheit in Form eines Glasprismas und einem Lichtsensor besteht. Jedem Lichtsensor ist eine Bewertungsschaltung und jeder Leuchtdiode eine eigene Stromversorgung zugeordnet, die in Steuerabhängigkeit von der Bewertungsschaltung steht. Um ein einwandfreies Arbeiten der optoelektronischen Schaltkreiselemente zu ermöglichen, sind deren Glasprismen in optischem Kontakt mit der Unterseite einer alle Schaltkreiselemente tragenden planparallelen Glasplatte mit Hilfe eines optischen Zements an dieser befestigt. Ein solches Tastenfeld ist flächenbeanspruchend und aufwendig.

Der Erfindung liegt die Aufgabe zugrunde, ein Tastenfeld der eingangs genannten Art zu schaffen, das einfach und platzsparend und gegen Umwelteinflüsse unempfindlich sicher betätigbar ist, wobei gleichzeitig eine Anzeige des Schaltzustandes erfolgt.

Die Lösung der gestellten Aufgabe gelingt durch die kennzeichnenden Maßnahmen nach dem Patentanspruch.

Die einzelnen LED's werden in Abhängigkeit von einer Steuereinrichtung im Zusammenwirken mit einer Zähleinrichtung fortlaufend mit so hoher Geschwindigkeit angesteuert, daß mit Sicherheit auch die jeweils vom Finger einer Bedienungsperson überdeckte Leuchtdiode zur Ansteuerung gelangt und dabei ihr vom Auge nicht erfaßbares Lichtsignal abgedeckt wird, so daß die Lichtsensoren gemeinschaftlich beim Ansteuern der abgedeckten Leuchtdiode den in der Zähleinrichtung zugeordneten Stromkreis in Aktivzustand versetzen, wozu die Lichtsensoren über ein Und-Glied auf die Zähleinrichtung und den von dieser abhängigen Stromkreis wirken. Mit der Aktivierung des eingeschalteten Stromkreises wird vorzugsweise durch die Steuereinrichtung im Zusammenwirken mit der Zähleinrichtung die Ansteuerdauer für die betätigte Leuchtdiode vom beispielsweise 100 µs auf eine wesentlich längere Zeit heraufgesetzt, so daß diese Leuchtdiode nach Wegnahme des Fingers für das Auge erkennbar lange vorübergehend leuchtet. Entsprechendes gilt für alle betätigten Leuchtdioden. Durch erneute Abdeckung einer verlängert leuchtenden Leuchtdiode kann deren verlängerte Ansteuerdauer wieder verkürzt und der von ihr beeinflußte Stromkreis wieder in den Ausgangszustand gebracht werden. Die Beeinflussung über das Und-Glied hat die Aufgabe, eine versehentlich mit Hand oder anderen Körpern vorgenommene teilweise Überdeckung einer oder mehrerer Leuchtdioden nicht zu einer ungewollten Aktivierung der zugeordneten Stromkreise zu veranlassen.

**Patentanspruch**

Tastenfeld mit einer Vielzahl eng benachbarter geordneter Einzeltaster zur Betätigung elektrischer Stromkreise, wobei jeder Einzeltaster eine Leuchtdiode aufweist und die Leuchtdioden von einer Steuer- und Zähleinrichtung fortlaufend für eine im Vergleich zur Betätigungsdauer kurze Zeit während der Betätigungsdauer angesteuert werden und bei einem betätigten Einzeltaster die Lichtemission der betreffenden Leuchtdiode auf einen Lichtsensor unterbunden ist, dadurch gekennzeichnet, daß jede Leuchtdiode selbst als abdeckbarer Einzeltaster ausgebildet ist, der durch eine vorübergehende Abdeckung in einen vorübergehend eingeschalteten Zustand und durch eine erneute Abdeckung in seinen Ausgangszustand gebracht werden kann, und mehrere mit allen Leuchtdioden in Sichtverbindung angeordnete Lichtsensoren vorgesehen sind, die über ein Und-Glied mit der Steuer- und Zähleinrichtung zusammenarbeiten, so daß nur bei gleichzeitiger Unterbrechung der Lichtsignale einer abgedeckten angesteuerten Leuchtdiode zu allen Lichtsensoren eine Betätigung des der betreffenden Leuchtdiode in der Zähleinrichtung zugeordneten Stromkreises und gleichzeitig eine Verlängerung der Ansteuerzeit der betätigten Leuchtdiode zur Abgabe von visuell erfaßbarem Licht erfolgt.

**Claim**

A bank of keys with a plurality of closely adjacent, ordered individual keys for the actuation of electric circuits, wherein each individual key possesses a luminescent diode and the luminescent diodes are continuously operated by a control and counting device during the operating time for a short period of time in comparison to the operating time, and when an individual key is operated the light emission of the assigned luminescent diode to a light sensor is suppressed, characterised in that each luminescent diode is itself designed as an individual key which can be covered and which, by being temporarily covered, can be brought into a temporarily switched-on state and by being again covered can be brought into its starting state, and a plurality of light sensors are provided which are visually linked to all the luminescent diodes and which co-operate with the control and counting device via an AND-gate, so that only in the event of the simultaneous interruption of the light signals of a covered, operated luminescent diode to all the light sensors is the circuit assigned to the relevant luminescent diode in the counting device actuated and at the same time there is an extension of the drive time of the operated luminescent diode for the emission of visually detectable light.

**Revendication**

Panneau de touches comportant une multiplicité de touches individuelles disposées d'une manière très rapprochée les unes des autres et servant à actionner des circuits électriques, et dans lequel chaque touche individuelle comporte une diode à luminescence et les diodes à luminescence sont commandées de façon continue par un dispositif de commande et de comptage pendant un intervalle de temps bref par rapport à la diode d'actionnement, au cours de cette durée, et dans lequel, lorsqu'une touche individuelle est actionnée, l'émission de lumière de la diode à luminescence concernée est interdite vers un détecteur de lumière, caractérisé par le fait que chaque diode à luminescence est réalisée sous la forme d'une touche individuelle pouvant être masquée, qui peut être amenée par masquage transitoire dans un état branché de façon transistoire et par un nouveau masquage dans son état initial, et qu'il est prévu plusieurs capteurs de lumière placés en liaison visuelle avec toutes les diodes à luminescence et qui coopèrent par l'intermédiaire d'un circuit ET avec le dispositif de commande et de comptage, de sorte que seulement lors de l'interruption simultanée des signaux lumineux d'une diode à luminescence commandée et masquée, en direction de tous les détecteurs de lumière, un actionnement du circuit, qui est associé dans le dispositif de comptage à la diode à luminescence concernée, et simultanément un prolongement de l'intervalle de temps de commande de la diode à luminescence actionnée sont réalisés pour la délivrance d'une lumière pouvant être détectée, visuellement.